# EUROPEAN PATENT SPECIFICATION

(11) **EP 2 880 645 B1**
(45) Date of publication and mention of the grant of the patent: **02.10.2019**
(21) Application number: 13827116.8
(22) Date of filing: 05.08.2013
(51) Int. Cl.: G08B 21/10, G01H 11/06, G01V 1/18, H03K 17/955, G01V 1/00

(54) **A MULTI-PURPOSE MONITORING SYSTEM SUITABLE FOR NATURAL DISASTER ALARMS**
VIELSEITIGES ÜBERWACHUNGSSYSTEM FÜR NATURKATASTROPHENALARME
SYSTÈME DE SURVEILLANCE MULTI-USAGES ADAPTÉ POUR DÉCLENCHER DES ALARMES DANS LE CAS DE CATASTROPHES NATURELLES

(30) Priority: 06.08.2012 SE 1200481
(43) Date of publication of application: 10.06.2015
(73) Proprietor: Wern, Lars Åke, 113 50 Stockholm (SE)
(72) Inventor: Wern, Lars Åke, 113 50 Stockholm (SE)
(74) Representative: Ehrner & Delmar Patentbyrå AB
(86) International application number: PCT/SE2013/050951
(87) International publication number: WO 2014/025304

(56) References cited:
- WO-A1-2011/105951
- WO-A1-2012/005646
- SE-A1- 1 050 896
- US-A1- 2007 063 837
- US-A1- 2008 270 034
- US-A1- 2008 309 486
- DAVIDE TRAPANI ET AL: "Validation of MEMS acceleration measurements for seismic monitoring with LVDT and vision system", ENVIRONMENTAL ENERGY AND STRUCTURAL MONITORING SYSTEMS (EESMS), 2012 IEEE WORKSHOP ON, IEEE, 28 September 2012 (2012-09-28), - 28 September 2012 (2012-09-28), pages 104-109, XP032472821, DOI: 10.1109/EESMS.2012.6348394 ISBN: 978-1-4673-2739-8
- MASCARENAS D ET AL: "A Mobile Host Approach for Wireless Powering and Interrogation of Structural Health Monitoring Sensor Networks", IEEE SENSORS JOURNAL, IEEE SERVICE CENTER, NEW YORK, NY, US, vol. 9, no. 12, 1 December 2009 (2009-12-01), - 1 December 2009 (2009-12-01), pages 1719-1726, XP011278691, ISSN: 1530-437X, DOI: 10.1109/JSEN.2009.2030706
- TOM TORFS ET AL: "Low Power Wireless Sensor Network for Building Monitoring", IEEE SENSORS JOURNAL, IEEE SERVICE CENTER, NEW YORK, NY, US, vol. 13, no. 3, 12 September 2012 (2012-09-12), - 12 September 2012 (2012-09-12), pages 909-915, XP011491795, ISSN: 1530-437X, DOI: 10.1109/JSEN.2012.2218680 [retrieved on 2012-09-12]

## Description

### Technical field

The invention relates to a multi-purpose monitoring system which is suitable for natural disaster alarms and in which a telecom network is provided with data processing means arranged to receive warning signals from a plurality of geographically dispersed vibration detectors and to send alarm messages to a group of receivers.

### Background of the invention

The US Patent 7 693 663 describes a method for detection of earthquakes and tsunamis and an interface to a warning system for the purpose. Accelerometers inside computer hard disk drives are proposed as data sources for post-event analysis of seismic events, such as earthquakes. The damage zone can be analyzed to help first responders determine where they should direct emergency resources and early warnings could be provided for tsunamis after earthquakes at the ocean floor. While the proposed method is cost-effective in large-scale applications, an improved post-event analysis of local damages is desirable.

### Summary of the invention

A multi-purpose monitoring system is devised which is particularly suitable for natural disaster alarms in cost-effective large-scale applications and in which means are provided for improved post-event analysis of local damages as set forth in the appended claims.

### Brief description of the drawing

The invention will now be described in detail with reference made to the drawing in which a block diagram is shown of a capacitive sensor that can provide cost-effectiveness in large-scale applications of the devised multi-purpose monitoring system.

### Preferred embodiment

The preferred embodiment of the multi-purpose monitoring system of the invention comprises a telecom network which is provided with data processing means arranged to receive warning signals from a plurality of geographically dispersed vibration detectors and to send alarm messages to a group of receivers. According to the invention, the detectors are arranged to monitor local capacitances between earth and electrically conductive construction elements of local objects and to send status reports on these to the data processing means subsequent the transmission of the warning signals and within a preset time window enabling post-event analysis of local damages before the transmission of the alarm messages.

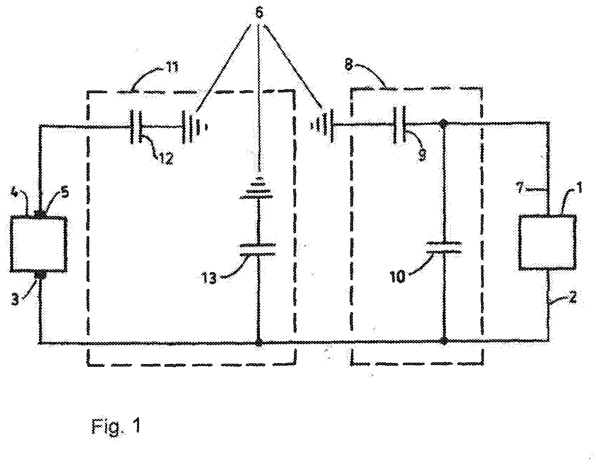

In figure 1, a block diagram shows a multi-purpose capacitive sensor. It can for the preferred embodiment of the invention provide cost-effectiveness in monitoring the local capacitances between earth and the electrically conductive construction elements in vehicles such as trucks or construction work machines, in base stations of the telecom network, in buildings that have entrance doors enforced with metal elements for prevention against intrusion, in refrigerator doors that are capable of new functionalities as described in the US Patent 8 049 518, in paintings provided with an electronic shield for proximity alarms, etc. A voltage measuring device 1 is provided with a signal ground 2 connected to a first pole 3 of an oscillating voltage source 4 that has a second pole 5 connected to earth 6 and that is connected to an input 7 of the voltage measuring device 1 via a voltage divider 8 with a capacitive series link 9 arranged between earth 6 and the input 7 and a capacitive shunt link 10 arranged between signal ground 2 and the input 7. The signal ground 2 is connected to said electrically conductive construction elements and the oscillating voltage source 4 is connected to earth 6 via a second voltage divider 11 in which a capacitive series link 12 is arranged between earth 6 and the second pole 5 and has an impedance of at least the same order of magnitude as the impedance of a capacitive shunt link 13 provided by the capacitance between the signal ground 2 and earth 6.

For applying this or other capacitive sensors to different embodiments of the invention, the man skilled in the art is referred to SE 533658, SE 535106 and SE 535150 as well as to WO 2011155891, WO 2011155893 and WO 2011105951. The latter document devises dynamic detection and warning strategies applicable to optimize the use of the receivers as well as of the detectors that send the status reports on local capacitances subsequent to the transmission of warning messages. In the case of an earthquake, the status reports can indicate destructive results after a secondary wave while the warning signals merely indicate a preliminary wave. In the above-described capacitive sensor, the voltage measuring device 1 is usable for detecting both these waves in a cost-effective and reliable way. As an option, it input 7 can be provided with a multiplexed connection for adding a low-cost electret microphone that is infrasound sensitive and reacts also to weak amplitudes of the preliminary wave.

The above-mentioned vehicles are suitable for receiving the alarm messages from the data processing means and providing in dependence thereon local alarms before arrival of destructive earthquake waves. Based on omnipresence where people live and work, the same goes for the base stations of the telecom network as well as for entrance doors that are enforced with metal elements for prevention against intrusion, intelligent refrigerators, paintings of such interest that they are provided with an electronic shield for proximity alarms, etc. It is known that providers of telecom services are around the world thinking of connecting billions of devices to data processing means. Large-scale application needs of cost-effective natural disaster alarms could be satisfied by including in their offers the multi-purpose monitoring system of the invention.

## Claims

1. A monitoring system which has multiple applications for natural disaster alarms and in which a telecom network is provided with data processing means arranged to receive warning signals from a plurality of geographically dispersed vibration detecting units and to send alarm messages to a group of receivers, **characterized thereby** that the vibration detecting units are also arranged to monitor local capacitances between earth (6) and the electrically conductive construction elements of local objects and to send status reports on these monitored capacitances to the data processing means subsequent to the transmission of the warning signals and within a preset time window enabling a post-event analysis of local damages before the transmission of the alarm messages.

2. A multi-purpose monitoring system according to claim 1, **characterized thereby** that the electrically conductive construction elements of the local objects are constituted by elements of vehicles housing the vibration detecting units.

3. A multi-purpose monitoring system according to claim 2, **characterized thereby** that the vehicles are trucks.

4. A multi-purpose monitoring system according to claim 2, **characterired thereby** that the vehicles are construction work machines.

5. A multi-purpose monitoring system according to claim 2, **characterized thereby** that the vehicles are arranged to receive the alarm messages from the data processing means and to provide in dependence thereon local alarms.

6. A multi-purpose monitoring system according to claim 1, **characterized thereby** that the electrically conductive construction elements are constituted by elements of base stations in the telecom network.

7. A multi-purpose monitoring system according to claim 6, **characterized thereby** that the base stations are arranged to receive the alarm messages from the data processing means and to provide in dependence thereon local alarms.

## Patentansprüche

1. Überwachungssystem, das mehrere Anwendungen für Naturkatastrophenalarme besitzt und in dem ein Telekommunikationsnetz mit einem Datenverarbeitungsmittel ausgestattet ist, das dazu eingerichtet ist, Warnsignale von mehreren geographisch verteilten Vibrationsdetektionseinheiten zu empfangen und Alarmnachrichten zu einer Gruppe von Empfängern zu senden, **dadurch gekennzeichnet, dass** die Vibrationsdetektionseinheiten auch dazu eingerichtet sind, lokale Kapazitäten zwischen Erde (6) und den elektrisch leitfähigen Konstruktionselementen von lokalen Objekten zu überwachen und Statusberichte über diese überwachten Kapazitäten zu dem Datenverarbeitungsmittel im Anschluss an die Übertragung der Warnsignale und innerhalb eines voreingestellten Zeitfensters zu senden, was eine Nach-Ereignis-Analyse von lokalen Schäden vor der Übertragung der Alarmnachrichten ermöglicht.

2. Mehrzweck-Überwachungssystem nach Anspruch 1, **dadurch gekennzeichnet, dass** die elektrisch leitfähigen Konstruktionselemente der lokalen Objekte aus Elementen von Fahrzeugen gebildet werden, in denen die Vibrationsdetektionseinheiten untergebracht sind.

3. Mehrzweck-Überwachungssystem nach Anspruch 2, **dadurch gekennzeichnet, dass** die Fahrzeuge Lastkraftwagen sind.

4. Mehrzweck-Überwachungssystem nach Anspruch 2, **dadurch gekennzeichnet, dass** die Fahrzeuge Baumaschinen sind.

5. Mehrzweck-Überwachungssystem nach Anspruch 2, **dadurch gekennzeichnet, dass** die Fahrzeuge dazu eingerichtet sind, die Alarmnachrichten vom Datenverarbeitungsmittel zu empfangen und in Abhängigkeit davon lokale Alarme bereitzustellen.

6. Mehrzweck-Überwachungssystem nach Anspruch 1, **dadurch gekennzeichnet, dass** die elektrisch leitfähigen Konstruktionselemente aus Elementen von Basisstationen im Telekommunikationsnetz gebildet werden.

7. Mehrzweck-Überwachungssystem nach Anspruch 6, **dadurch gekennzeichnet, dass** die Basisstationen dazu eingerichtet sind, die Alarmnachrichten vom Datenverarbeitungsmittel zu empfangen und in Abhängigkeit davon lokale Alarme bereitzustellen.

## Revendications

1. Système de surveillance ayant des applications multiples pour des alarmes en cas de catastrophes naturelles et dans lequel un réseau de télécommunications est muni de moyens de traitement de données agencés pour recevoir des signaux d'avertissement d'une pluralité d'unités de détection de vibrations dispersées géographiquement et pour envoyer des messages d'alarme à un groupe de récepteurs, **caractérisé en ce que** les unités de détection de vibrations sont également agencées pour surveiller des capacités locales entre la terre (6) et les éléments de construction électroconducteurs d'objets locaux et pour envoyer aux moyens de traitement de données des rapports de situation concernant ces capacités surveillées suite à la transmission des signaux d'avertissement et dans la limite d'une fenêtre de temps préréglée permettant une analyse après l'évènement de dommages locaux avant la transmission des messages d'alarme.

2. Système de surveillance multi-usages selon la revendication 1, **caractérisé en ce que** les éléments de construction électroconducteurs des objets locaux sont composés d'éléments de véhicules logeant les unités de détection de vibrations.

3. Système de surveillance multi-usages selon la revendication 2, **caractérisé en ce que** les véhicules sont des camions.

4. Système de surveillance multi-usages selon la revendication 2, **caractérisé en ce que** les véhicules sont des engins de travaux.

5. Système de surveillance multi-usages selon la revendication 2, **caractérisé en ce que** les véhicules sont agencés pour recevoir les messages d'alarme des moyens de traitement de données et pour fournir des alarmes locales en fonction de ceux-ci.

6. Système de surveillance multi-usages selon la revendication 1, **caractérisé en ce que** les éléments de construction électroconducteurs sont composés d'éléments de stations de base dans le réseau de télécommunications.

7. Système de surveillance multi-usages selon la revendication 6, **caractérisé en ce que** les stations de base sont agencées pour recevoir les messages d'alarme des moyens de traitement de données et pour fournir des alarmes locales en fonction de ceux-ci.
